# EUROPEAN PATENT APPLICATION

(11) **EP 1 624 496 A1**
(43) Date of publication of application: **08.02.2006**
(21) Application number: 04729779.1
(22) Date of filing: 27.04.2004
(51) Int. Cl.: H01L 33/00

(54) **LIGHT-EMITTING DIODE**

(30) Priority: 30.04.2003 RU 2003113362
(71) Applicant: Zakrytoe Aksionernoe Obschestvo "Innovatsionnaya Firma "Tetis", St. Petersburg, 194156 (RU)
(72) Inventor: VASILIEVA, Elena Dmitrievna, St.Petersburg, 197371 (RU); ZAKGEIM, Aleksandr Lvovich, St.Petersburg, 197371 (RU); ZAKGEIM, Dmitry Aleksandrovich, St.Petersburg, 197371 (RU); GUREVICH, Sergei Aleksandrovich, St.Petersburg, 194100 (RU); ITKINSON, Grigory Vladimirovich, St. Petersburg, 197119 (RU); ZHMAKIN, Aleksandr Igorevich, St.Petersburg, 192239 (RU)
(74) Representative: Jeck, Anton
(86) International application number: PCT/RU2004/000175
(87) International publication number: WO 2004/097950

(57) **Zusammenfassung**

Die Lichtemissionsdiode gemäß der Erfindung umfasst ein Substrat (1), eine epitaxiale Heterostruktur auf der Basis von festen Losungen von Metallnitriden der dritten Gruppe Alₓln_{y}GA_{1-(x+y)}N (O ≤ x ≤ 1; 0 ≤ y ≤ 1) mit einem p-n-Übergang, der durch die Reihenfolge von epitaxialen Schichten (2 und 4) des n- und p-Leitfähigkeitstyps gebildet ist, Metallkontakte, die auf der Seite der epitaxialen Schichten liegen, wobei mindestens ein Metallkontakt auf der Außenoberfläche der epitaxialen Schichten angeordnet ist. Das Substrat (1) ist aus einem Monokristall aus einem Metallnitrid der dritten Gruppe A^{III}N ausgeführt. In den epitaxialen Schichten auf der Seite der Außenoberfläche ist eine Mezzastruktur gebildet, in der eine Nut (7) in solcher Tiefe ausgeätzt ist, die größer als die Übergangstiefe des p-n-Übergangs ist. Diese Nut teilt die Mezzastruktur in zwei Bereiche. Ein Metallkontakt (5) ist auf der Außenoberfläche eines Bereichs (A) der Mezzastruktur angebracht, und ein weiterer Metallkontakt (6) ist auf der Außenoberfläche eines anderen Bereiches (B) der Mezzastruktur angebracht und dabei an der Seitenwand der Nut (7) auf deren Boden gelegt.

## Description

Die Erfindung bezieht sich auf das Gebiet der Halbleiteremissionsgeräte, und zwar auf LEDs auf der Basis der Nitridverbindungen von Metallen der III. Gruppe, nämlich Aluminium, Gallium, Indien (A^{III}N).

In den letzten Jahre fanden LEDs der Ultraviolett-, Blau- und Grünlichtspektralbereiche auf der Basis der epitaxialen Heterostruktur mit p-n-Übergang im System der festen Lösungen AllnGaN, die auf dem monokristallinen Substrat gezüchtet sind, eine breite Verbreitung. In den angegebenen LEDs wird am häufigsten als Material des Substrates Saphir AL2O₃ [vgl. beispielsweise US 5 563 422] oder Siliziumkarbid SiC [vgl. beispielsweise US 2002/0121642 A1] verwendet.

In den genannten Geräten besitzen die Substrate und epitaxialen Schichten der Heterostruktur sich voneinander stark unterscheidende Kristallgitterkonstanten und Wärmeausdehnungskoeffizienten. Dies führt unvermeidlich zu einer großen Versetzungsdichte (ca. 10⁹-10¹⁰ cm⁻²) und zum Erscheinen anderer Störungstypen (beispielsweise Störungen der Packung und der Inversionsdomänen) am Umfang des Geräts, wodurch grundsätzlich solche Geräteparameter, wie der innere Quantenwirkungsgrad der Strahlungen, die Betriebsmittel für den Gerätebetrieb usw., eingeschränkt werden.

Außerdem muss in den Fällen, in denen in den zu behandelnden LED-Konstruktionen die Strahlung über die obere p-Schicht hinausgeführt wird, die über eine niedrige, elektrische Leitungsfähigkeit verfügt, halbdurchsichtige Metallkontakte benutzen, die große, optische und elektrische Verluste verursachen.

Zurzeit werden Technologien zur Gewinnung der Substrate aus den räumlichen Einkristallen von Galliumnitrid GaN und Aluminiumnitrid AIN mit einer kleinen Versetzungsdichte [vgl. beispielsweise das Verfahren zur Gewinnung des AIN-Substrats durch Sublimation, beschrieben in RU 2158789] entwickelt. Die genannten Substrate sind außerordentlich aussichtsreich für den Einsatz in LEDs mit Al-lnGaNeptaxialer Heterostruktur, da Kristallgitterkonstanten und Wärmeausdehnungskoeffizienten des Substratmaterials und der darauf gezüchteten, epitaxialen Heterostruktur nahe sind, so dass sich die Menge der Defekte am Umfang der LED minimisieren und sein innerer Quantenwirkungsgrad erhöhen lässt. Um die Entwicklung solcher LEDs geht es in der Arbeit PARC und Crystal IS demonstrate AIN-based UVLED, III-Vs Review, Vol.15, Nr. 4 (2002) S. 20. In dieser LED wird jedoch die Strahlung über die obere p-Schicht herausgeführt, so dass ihr Defekte eigen sind, die mit der Verwendung eines halbdurchsichtigen, metallischen p-Kontakts verbunden sind.

Es sind LEDs mit einer AlGalnN-eptaxialen Heterostruktur bekannt, die auf einem durchsichtigen Saphirsubstrat gezüchtet sind, in dem das Licht durch das durchsichtige Substrat herausgeführt wird. Die beiden Kontaktplätze (schon nicht halbdurchsichtige, sondern vorzugsweise abspiegelnde) sind von der Seite der epitaxialen Schichten (der Kristallhinterseite) untergebracht und zwecks der nachfolgenden Anbringung des Kristalls auf der Schaltkarte mit dem "flip-chip"-Verfahren verwendet werden [vgl. beispielsweise US 6 169 294 B; US 6 514 782 B1; J.C. Bat et al., High Efficiency Monochromatic and White InGaN-Flip-Chip Dice; J. Wierer, D. Steigewald et.al., High-power AlGaInN-flip-chip light emitting diodes, Appl. Phys. Lett. 78, 2001, S. 3379].

Als Prototyp wurde von den Erfindern die AlGalnN-LED auf einem Saphirsubstrat gewählt, bei dem beide Metallkontakte von der Seite der epitaxialen Schichten liegen und das Licht durch das Substrat herausgeführt wird [US 6 521 914 B2]. In dieser LED liegt der Metallkontakt zur Schicht der p-Typ-Leitfahigkeit auf der Außenoberfläche der epitaxialen Schichten, und der Metallkontakt zur Schicht der n-Typ-Leitfähigkeit ist auf dem Niveau der erwähnten Schicht untergebracht; dabei wird zum Öffnen der n-Typ-Schicht das Ätzen eines Teils der eptaxialen Heterostruktur durchgeführt.

In der erwähnten LED-Konstruktion fehlen optische und elektrische Verluste, die mit dem Herausführen der Strahlung über den halbdurchsichtigen Kontakten verbunden sind.

Jedoch hat diese Konstruktion die Nachteile, dass das Substrat aus Saphir ist und die Schichten der Heterostruktur sich stark voneinander unterscheidende Kristallgitterkonstanten und Wärmeausdehnungskoeffizienten aufweisen. Außerdem wird für diese LED-Konstruktion folgender Mechanismus zur Beschränkung des Herausführens der zu erzeugenden Strahlung aus dem Kristallvolumen relevant: wegen der Differenz zwischen den Brechungskoeffizienten des Saphirsubstrats (n~ 1,8) und den AlGalnN-epitaxialen Schichten (n~ 2,3) erfolgt die Erfassung der Strahlung im dadurch gebildeten Wellenleiter, in dem die Strahlung durch die Volumen- und Oberflächenabsorption (an den Kontakten) verloren wird. Besonders relevant ist dieser Mechanismus für die leistungsfähigen Kristalle mit großer Fläche.

Zum Nachteil der Prototyp-Konstruktion zählt auch die Unebenheit (unterschiedliche Höhen) der Metallkontakte in Bezug auf die Schichten der n- und p-Typ-Leitfahigkeit, da im Falle der Unebenheit der Kontakte die Montage der lichtstrahlenden Diode auf der Schaltkarte komplizierter wird.

Diese Erfindung hat die Aufgabe, den Quantenwirkungsgrad der AlGaln-LEDs zu erhöhen und die Montage dieser LEDs auf der Schaltkarte zu vereinfachen.

Diese Aufgabe wird dadurch gelöst, dass die Lichtemissionsdiode folgendes enthält: ein Substrat, eine eptaxiale Heterostruktur auf Basis von festen Lösungen von Metallnitriden der dritten Gruppe Alₓln_{y}Ga_{1-(x+z)}N, (0 ≤ x ≤ 1, 0≤ y ≤ 1) mit einem n-p-Übergang, der mit der Reihenfolge der epitaxialen Schichten der n- und p-Typ-Leitfähigkeit gebildet ist, und Metallkontakte, die sich an der Seite der epitaxialen Schichten befinden, wobei mindestens einer der Metallkontakte auf der Außenoberfläche der epitaxialen Schichten liegt; gemäß der Erfindung ist das Substrat aus einem Monokristall aus dem Metallnitrid der dritten Gruppe A^{III}N gebildet; in den eptaxialen Schichten ist von der Seite der Außenoberfläche eine Mezzastruktur gebildet, in der eine tiefe Rinne ausgeätzt ist, deren Tiefe größer als die Übergangstiefe des p-n-Übergangs ist, die die Mezzastruktur in zwei Bereiche teilt; einer der Metallkontakte liegt auf der Außenoberfläche eines Bereichs der Mezzastruktur, und ein anderer Metallkontakt liegt auf der Außenoberfläche des anderen Bereichs der Mezzastruktur und liegt dabei an der Seitenwand der Rinne auf deren Boden auf.

Es ist zweckmäßig, dass, falls die Fläche desjenigen Bereichs der Mezzastruktur, die einen Metallkontakt nur auf ihrer Außenoberfläche aufweist, 0,1 mm² überschreitet, darin innere Nuten ausgeführt werden, die die Fläche in der Gesamtheit der Mezzastruktur teilen.

Eine Variante der Ausführung der LED ist möglich, bei der die Höhe der Mezzastruktur die Stärke der epitaxialen Schichten überschreitet.

Es ist zweckmäßig, dass, falls das Substrat aus einem stromleitenden Material ausgeführt ist, die Tiefe der Nut und/oder die Tiefe der inneren Nuten, die die Mezzastruktur in der Gesamtheit der Mezzastrukturen teilen, die Stärke der epitaxialen Schichten überschreitet.

Es ist zweckmäßig, dass die Seitenwände der Mezzastruktur und/oder die Seitenwände der Nut und/oder die Seitenwände der inneren Nuten, die die Mezzastruktur in die Gesamtheit der Mezzastrukturen teilen, einen Winkel von 25-60° der Vertikalen zur Substratfläche aufweisen.

Es ist zweckmäßig, dass auf der Oberfläche des Substrats mittels des Ätzverfahrens ein Mikrorelief mit einem charakteristischen Maß von 0,1-0,3 mm erzeugt wird.

Es ist zweckmäßig, dass die Substratstärke für die Formgebung als Hemisphäre mit dem Mittelpunkt ausreichend ist, der mit dem geometrischen Mittelpunkt desjenigen Bereichs der Mezzastruktur, der einen Metallkontakt nur auf der Außenoberfläche der Mezzastruktur aufweist, oder mit dem geometrischen Mittelpunkt der Gesamtheit der Mezzastrukturen übereinstimmt.

Durch die Verwendung in der angemeldeten Vorrichtung der AlGalnN-epitaxialen Heterostruktur, die auf dem Substrat aus dem Monokristall aus Metallnitrid der dritten Gruppe A"'N gezüchtet ist, wird ein hoher innerer Quantenwirkungsgrad der ausstrahlenden Rekombination in der LED erreicht, die durch eine niedrige Menge an Defekten am Umfang des Geräts bedingt ist. Infolge der Nähe der Brechungskoeffizienten der eptaxialen Heterostruktur und des Substrats werden die günstigen Bedingungen für das Herausgehen der Strahlung aus den epitaxialen Schichten in das Substrat gewährleistet. Zur Verbesserung der optischen Eigenschaften der LED trägt auch die Tatsache bei, dass die Metallkontakte an der Seite der epitaxialen Schichten liegen; dabei wird das Licht über das durchsichtige Substrat herausgeführt.

Durch die Formierung von der Seite der Außenoberfläche der epitaxialen Schichten der Mezzastruktur, deren Seitenwände die Rolle von Mikroreflektoren erfüllen, indem sie die innerhalb des Kristalls erzeugte Strahlung in Richtung der Schaufläche (lichtherausführend) richten, erhöht sich der Quantenwirkungsgrad der LED gemäß der Erfindung.

Die Ausführung der Nuten in den epitaxialen Schichten, die eine Tiefe größer als die p-n-Übergangstiefe aufweisen, bedingt die Teilung der epitaxialen Schichten in zwei Bereiche. Dabei erweist es sich durch das Vorhandensein der genannten Nut als möglich, die Ebenheit (die Unterbringung auf der gleichen Höhe) der Metallkontakte in Bezug auf die Schichten der n-und p-Typ-Leitfähigkeit zu gewährleisten; einer der Metallkontakte liegt auf der Außenoberfläche der epitaxialen Schichten eines Bereichs (des strahlenden Bereichs), und ein anderer Metallkontakt liegt auf der Außenoberfläche des anderen Bereichs und ist an der Seitenwand der Rinne auf deren Boden gelegt. Die Ebenheit der Metallkontakte vereinfacht die Montage der LED auf der Schaltkarte.

Wie die experimentellen Forschungen der Erfinder gezeigt haben, gilt es in demjenigen Fall, in dem die Fläche des ausstrahlenden Bereichs der Mezzastruktur 0,1 mm² überschreitet, aus der Sicht der Erhöhung der Wirksamkeit als zweckmäßig, beim Herausführen der Strahlung die Teilung des genannten Bereichs in der Gesamtheit der Mezzastrukturen mit kleinerer Fläche mittels der zu ätzenden, inneren Nuten vorzunehmen.

In demjenigen Falle, in dem die Höhe der Mezzastruktur die Stärke der epitaxialen Schichten überschreitet und in dem die Tiefe der Nut und der inneren Nuten die Stärke der epitaxialen Schichten überschreitet, steigt der Anteil der Strahlen, die von den Seitenwänden der Mezzastruktur oder von den Seitenwänden der genannten Rinnen in Richtung des Substrats zurückgespiegelt werden und dabei ihre Richtung so ändern, dass sie die Grenze des Substrats treffen, nämlich die Luft unter dem Winkel, der geringer als der Winkel der vollen, inneren Reflexion ist, wodurch der äußere Quantenwirkungsgrad der LED erhöht wird.

Die von den Erfindern durchgeführten Berechnungen im Modell mit der Trassierung aller Strahlen, die im Umfang des Kristalls erzeugt werden, zeigen, dass es für die Vergrößerung des Anteils der Strahlen, die von den Seitenwänden der Mezzastruktur und von den Seitenwänden der Nut und der inneren Rinnen zurückgespiegelt werden, notwendig ist, dass die genannten Seitenwände einen Winkel von 25-60° der Vertikalen zur Substratfläche aufweisen.

Das Vorhandensein des Mikroreliefs auf der Oberfläche des Substrats mit einem charakteristischen Maß von 0,1-0,3 µm, wobei das Mikrorelief das Zerstreuen der Strahlen verursacht, die nicht mit dem ersten Durchgang aus dem Umfang des Kristalls herausgegangen sind, erhöht die Wahrscheinlichkeit des Ausgangs der Strahlen nach einigen Durchgängen durch den zufälligen Wechsel der Richtung der Verbreitung und des Gelangens in einen Winkel, der weniger kritisch ist, wodurch die Erhöhung der Wirksamkeit des Herausführens der Strahlung aus der LED erreicht wird. In demjenigen Fall, in dem die Außenoberfläche des Substrats die Form einer Halbkugel aufweist, deren Zentrum mit dem geometrischen Zentrum des ausstrahlenden Bereichs der Mezzastruktur übereinstimmt, erhöht sich die Wirksamkeit des Herausführens der Strahlung aus der LED, da alle Strahlen, die aus dem Zentrum des ausstrahlenden Bereichs herausgehen, auf die Grenze Substrat-Luft unter einem rechten Winkel gelangen und demnach den Kristall verlassen (die Verluste bei der Fresnel-Reflexion betragen 16 %).

### Kurzbeschreibung der Zeichnungen

Die Erfindung wird nun anhand von in Zeichnungen dargestellten Ausführungsbeispielen näher erläutert. Es zeigen:
- Fig.1: eine Gesamtansicht der LED gemäß der Erfindung (Ansicht von der Seite der epitaxialen Schichten und der Metallkontakte),
- Fig. 2: einen Schnitt durch die LED der Fig. 1 in der senkrechten Ebene; in diesem Schnitt sind schematisch die Wege der Verbreitung der Lichtstrahlen im Umfang des Geräts und des Ausgangs nach draußen dargestellt,
- Fig. 3: einen Schnitt durch eine LED, die als Prototyp gewählt wurde,
- Fig. 4: einen Schnitt durch die LED gemäß der Erfindung, bei der im ausstrahlenden Bereich der Mezzastruktur innere Nuten vorgesehen sind, die sie in der Gesamtheit der Mezzastrukturen teilen,
- Fig. 5: einen Schnitt durch die LED gemäß der Erfindung, bei der die Höhe der Mezzastruktur die Stärke der epitaxialen Schichten überschreitet,
- Fig. 6: einen Schnitt durch die LED gemäß der Erfindung, bei der die Seitenwände der Mezzastruktur einen Winkel von 25-60° der Vertikalen zur Substratfläche aufweisen, wobei auf der Oberfläche des Substrats ein Mikrorelief gebildet ist, und
- Fig. 7: einen Schnitt durch die LED gemäß der Erfindung, bei der das Substrat die Form einer Halbkugel aufweist.

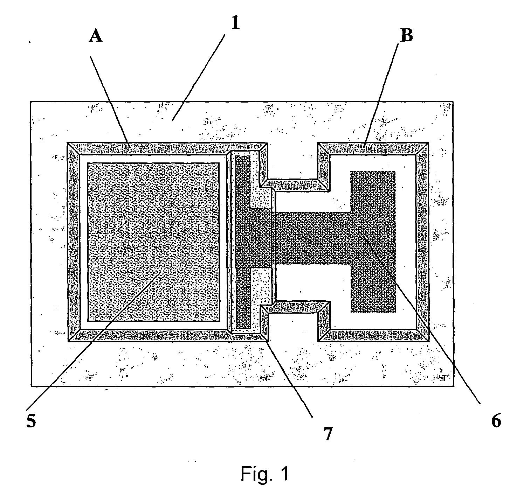

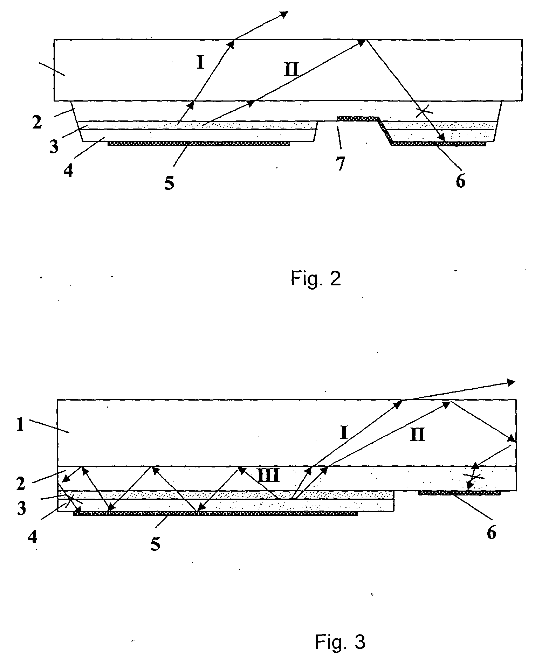

Die in den Figuren 1, 2 und 4 - 7 dargestellte LED enthält ein Substrat 1, das aus einem Monokristall aus Metallnitrid der dritten Gruppe A^{III}N, insbesondere aus einem räumlichen Barren aus Aluminiumnitrid AIN, nach derjenigen Technologie hergestellt ist, die in der RU 2158789 beschrieben ist. Die LED enthält auch eine epitaxiale Heterostruktur auf der Basis von festen Lösungen von Metallnitriden der dritten Gruppe Alₓln_{y}Ga_{1-(x+z})_{·}N, (0 ≤ x ≤1, 0 ≤y ≤1), gezüchtet mit dem Verfahren der Gasphasenepitaxie aus metallorganischen Verbindungen auf dem Substrat 1, das folgendes aufweist (Figuren 2, 4 - 6): eine dem Substrat n-AlₓGa₁₋ₓN am nächsten liegende Sperrschicht 2 (stromleitende Schicht vom n-Leitfähigkeitstyp), eine n-InₓGa₁₋ₓN-aktive Schicht 3, die einen p-n-Übergang einschließt, und eine p-AlₓGa₁₋ₓN-Sperrschicht 4 (eine stromleitende Schicht vom p-Leitfähigkeitstyp). Die LED enthält auch einen Metallkontakt 5 zur Schicht vom p-Leitfähigkeitstyp und einen Metallkontakt 6 zur Schicht vom n-Leitfähigkeitstyp. In den erwähnten, epitaxialen Schichten von den Seiten der Außenoberfläche ist eine Mezzastruktur gebildet, in der eine Nut 7 eingeätzt ist, welche die epitaxiale Schichten (Fig. 1) in den Bereich A (ausstrahlend) und Bereich B (Kontakt) teilen. Dabei ist der Metallkontakt 6 zur Schicht vom n-Leitfähigkeitstyp auf der Oberfläche der epitaxialen Schichten angebracht, die im Bereich B liegen, und ist an der Seitenwand der Nut 7 auf ihren Boden heruntergelassen. Der Metallkontakt 5 zur Schicht vom p-Leitfähigkeitstyp ist auf der Oberfläche der epitaxialen Schichten angebracht, die im Bereich A der Mezzastruktur liegen.

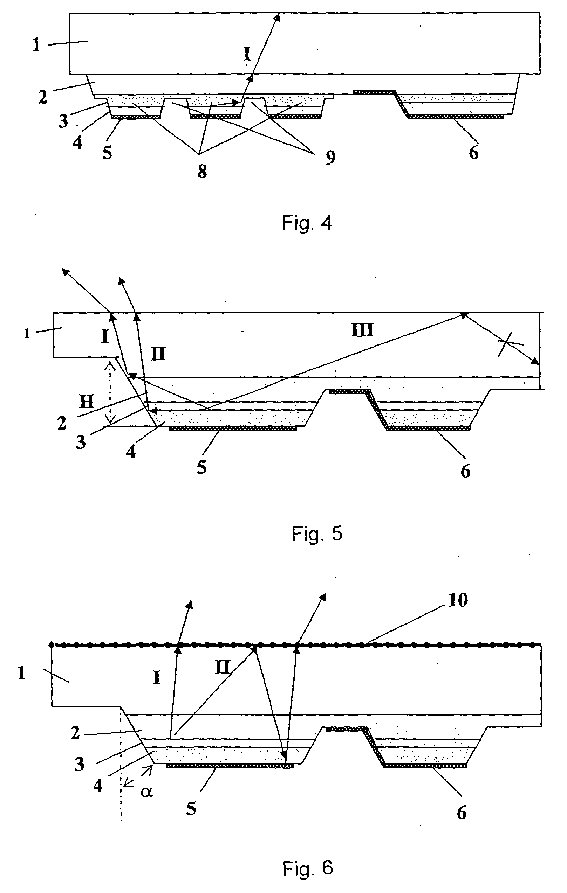

Wie experimentelle Forschungen der Erfinder gezeigt haben, falls die Fläche des Bereichs A der Mezzastruktur 0,1mm² überschreitet, ist es zweckmäßig, diese in der Gesamtheit der Mezzastruktur 8 mit kleiner Fläche (Fig. 4) mit Hilfe von auszuätzenden Rinnen 9 zu teilen.

Das Gerät funktioniert in folgender Weise.

Die LED wird mit dem "flip-chip"-Verfahren aufgebaut. Dabei werden die Kontakte 5 und 6, die auf einer Ebene liegen, an den jeweiligen Elektroden der Schaltkarte angelötet. Wenn Strom durch LED fließt, beginnt sie Licht auszustrahlen.

In den Figuren 2, 4-7 sind mit Pfeilen I, II, III unterschiedliche Wege der Verbreitung und des Ausgangs nach draußen der von der LED (Erfindung) erzeugten Strahlung gekennzeichnet.

Zum Vergleich sind in Fig. 3 die Wege der Verbreitung und des Ausgangs nach draußen der Strahlung gezeigt, die von der LED auf dem Saphirsubstrat erzeugt wird, die als Prototyp gewählt ist. Dabei werden für die Bezeichnung der gleichen Elemente der LED-Konstruktion die gleichen Positionen wie für die LED gemäß der Erfindung verwendet.

Für die LED gemäß der Erfindung unterscheiden sich die n-Brechungskoeffizienten des Substrats aus dem räumlichen Aluminiumnitrid AIN und AlGaltiN der epitaxialen Schichten 2, 3, 4 schwach, und diese Koeffizienten haben den Wert 2,3. Das Beieinanderliegen der Brechungskoeffizienten bedingt die Tatsache, dass (Fig. 2) die optische Grenze der epitaxialen Schicht 2 mit dem Substrat 1 praktisch fehlt; die Strahlen unter beliebigen Winkeln, beispielsweise I oder II, gehen über die Grenze "epitaxiale Schicht-Substrat" ohne Brechung durch und werden in das Substrat hineingeführt. Die Strahlen II, die in das Substrat hineingeführt sind, jedoch sich unter dem Winkel verbreiten, der größer als die volle, innere Reflexion für die Grenze Substrat-Luft ist, erfahren eine volle, innere Reflexion und können den Kristall mit dem ersten Durchgang nicht verlassen, jedoch gibt es in den unten erwähnten Varianten der Ausführung der Erfindung (Figuren 5, 6 und 7) Konstruktionseinzelheiten, die solche Verluste der Strahlung zu verringern erlauben.

In der in Fig. 3 dargestellten LED, die als Prototyp gewählt ist, hat das Saphirsubstrat einen n-Brechungskoeffizient vom Wert 1,8. Dies bedeutet, dass der Winkel α_{c} der vollen Reflexion an der Grenze "epitaxale Schicht 2 - Saphirsubstrat 1 ", der als α_{c}= arcsin(1.8/2.4) definiert ist, den Wert 48° aufweist, und dass der Anteil des Lichts, das im Wellenleiter aus dem gesamten Strahlungsstrom stammt, jeweils nach der bekannten Formel 4sin²24° = 66% beträgt. Wie in Fig. 3 veranschaulicht ist, ist für die Strahlen III, die im Wellenleiter vorhanden sind und die vielfache Reflexionen auf dem Weg zur Stirnseite der LED erfahren, die Wahrscheinlichkeit der Absorptionen sowohl im Umfang der epitaxialen Schichten wegen der großen Weglänge als auch bei den Reflexionen vom Metallkontakt hoch.

In Fig. 4 ist ein Schnitt durch die LED dargestellt, in dem der Bereich A der Mezzastruktur (Fig. 1), die eine größere Fläche hat, in kleinere Mezzastrukturen 8 durch die in den epitaxialen Schichten ausgeätzten, inneren Rinnen 9 geteilt ist. Bei dieser Variante der LED-Konstruktion für die gleitenden Strahlen (die unter kleinen Winkeln zur Substratebene laufen) reduziert sich die Weglänge im am meisten absorbierenden Bereich der LED, der mit den epitaxialen Schichten legiert ist. Außerdem bilden die inneren Nuten 9 zusätzliche Grenzen der Mezzastrukturen 8; dabei erhöht sich die Wahrscheinlichkeit des Ausgangs der erzeugten Strahlen aus dem Kristall über die genannten Grenzen sowie die Wahrscheinlichkeit der Veränderungen der Richtung bei der Verbreitung zur Seite des Substrats bei der Reflexion von diesen Grenzen. Die von den Erfindern durchgeführten Berechnungen zeigen, dass die Erhöhung der Wirksamkeit bei der Herausführung der Strahlung mit der Reduzierung der Fläche der Mezzastruktur in hohem Maße vom konkreten Wert des Lichtabsorptionskoeffizienten k in den epitaxialen Schichten abhängt. Für die realen Werte ist es vorteilhaft, wenn die Fläche der elementaren Mezzastruktur 8 den Wert 0,1 mm² nicht überschreitet.

In Fig. 5 ist ein Schnitt durch die LED dargestellt, in dem im Bereich A die Höhe H der Mezzastruktur die Stärke der epitaxialen Schichten überschreitet. Die Möglichkeit der Formierung der Mezzastruktur mit dieser großen Höhe H und auch die Möglichkeit der Ätzung der Rinnen 7 und inneren Rinnen 9, deren Tiefe die Stärke der epitaxialen Schichten (in Fig. 5 nicht gezeigt) überschreitet, ist durch die Verwendung von Nitridsubstraten bei der Erfindung bedingt, für die Verfahren der trockenen oder chemischen Ätzung auf jener Fläche der Seitenwand der Mezzastruktur angewendet werden, auf deren Höhe die Stärke der epitaxialen Schichten überschritten wird. Die Steigerung der Höhe H der Mezzastruktur sowie die Vergrößerung der Tiefe von Rinnen 7 und 9 vergrößert den Anteil der Strahlen, die von den Seitenwänden der Mezzastruktur oder von den Seitenwänden der genannten Rinnen zu der Seite des Substrates 1 abgespiegelt sind und die dabei ihre Richtungen so verändern, dass sie die Grenze des Substrates Luft unter einem Winkel treffen, der kleiner ist als der Winkel der vollen inneren Reflexion. Schematisch wird es auf der Fig. 5 veranschaulicht, wo der Strahl II, der auf jene Fläche der Seitenwand der Mezzastruktur fällt, auf der ihre Höhe die Stärke der epitaxialen Schichten überschreitet aus der LED herausgeht und der zu ihm symmetrische Strahl III, der auf die Fläche der Seitenwand der Mezzastruktur fällt, die in der Höhe liegt, die die Stärke der epitaxialen Schichten nicht überschreitet, kann die LED nicht verlassen. Auf solche Weise trägt die Vergrößerung der Höhe der Mezzastruktur zur Erhöhung des Quantenwirkungsgrads der LED-Strahlung bei. Alles Obengesagte gilt auch rechtmäßig für die Tiefe der Rinnen 7 und 9. Eine genauere Vorstellung über den Einfluss der Höhe der Mezzastruktur und der Tiefe der Rinnen auf die Wirksamkeit der Herausführung des Lichts geben die von den Erfindern durchgeführten Berechnungen im Rahmen des Modells der Trassierung der erzeugenden Strahlung, die die bemerkenswerte Erhöhung der optischen Wirksamkeit der Konstruktion bei der Erhöhung der erwähnten Parameter bestätigen. Dabei ist zu erwähnen, dass die Ausführung der Rinnen 7 und 9 mit der Tiefe, die die Stärke der epitaxialen Schichten überschreitet, nur für den Fall des stromleitenden Substrats (beispielsweise Substrat aus GaN) möglich ist, wobei Strom nicht nur über die epitaxialen Schichten, sondern auch im Substrat fließen kann. Für den Fall des isolierenden Substrats (beispielsweise Substrat aus AIN) ist die Tiefe der Rinnen 7 und 9 durch das Erreichen der n-Schicht eingeschränkt, da bei der Nichteinhaltung dieser Bedingung die Möglichkeit des Durchfließens von Strom durch den Kristall verschwindet.

In Fig. 6 ist ein Schnitt durch die LED dargestellt, in dem der Winkel α der Neigung der Seitenwände der Mezzastruktur im Bereich A, bezogen auf die Vertikale zur Ebene des Substrates 1, gezeigt ist. Dabei ist auf der Oberfläche des Substrats 1 mit dem Verfahren der Maskierung und der Ätzung ein Mikrorelief 10 mit einem charakteristischen Maß von 0,1-0,3 µm gebildet.

Der vorgegebene Wert des Winkels α wird durch die Wahl der Maskierung und der Ätzungsmodi erreicht. Aus der geometrischen Sicht, die in Fig. 6 veranschaulicht ist, ist erkennbar, dass der Winkel α derart gewählt werden muss, dass der gleitende Strahl I (parallel zu den Ebenen der epitaxialen Schichten) beim Fallen auf die Seitenwand der Mezzastruktur eine volle innere Reflexion erfährt und sich umgekehrt zur Seite des Substrats 1 erweisen soll. Bei einem Brechungskoeffizient von n=2,3 der epitaxialen AllnGaN-Schichten ist es leicht zu zeigen, dass der Winkel I nicht geringer als 25° sein darf. Die von den Erfindern durchgeführten Berechnungen im Modell mit der Trassierung aller Strahlen, die im Umfang des Kristalls erzeugt werden, zeigen, dass die optimalen Winkel der Neigung der Seitenwand der Mezzastruktur im Bereich von 25-60° liegen. Alles Obengesagte gilt auch für den Bereich der optimalen Werte des Winkels (auch in Fig. 6 nicht gezeigt) der Neigung der Seitenwände der Rinnen 7 und 9.

Das Mikrorelief 10 verursacht das Zerstreuen der Strahlen II, die mit dem ersten Durchgang aus dem Kristall nicht herausgegangen sind, und erhöht die Wahrscheinlichkeit des Ausgangs dieser Strahlen nach einigen Durchgängen durch den zufälligen Wechsel der Richtung bei der Verbreitung und Gelangen in der Winkel, der geringer als der kritische Winkel ist, dadurch wird die Erhöhung der Wirksamkeit bei der Herausführung der Strahlung aus der LED erreicht.

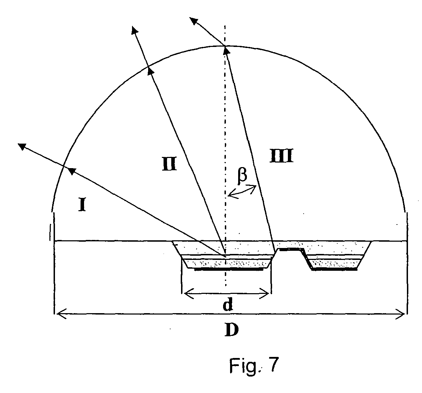

In Fig. 7 ist ein Schnitt durch die LED dargestellt, in dem die Außenoberfläche des Substrats 1 gekrümmt ausgeführt ist, insbesondere hat die Außenoberfläche die Form einer Halbkugel, deren Zentrum mit dem geometrischen Zentrum des ausstrahlenden Bereichs der Mezzastruktur übereinstimmt. Eine solche Form der Außenoberfläche des Substrats 1, ausgeführt aus Aluminiumnitrid AIN, das ein verhältnismäßig weiches Material ist, kann mit einer mechanischen Schleife erreicht werden. Im Falle einer richtig gewählten Krümmung der Außenoberfläche des Substrats 1, wie es in Fig. 7 gezeigt ist, fallen alle Strahlen, die aus dem Zentrum des ausstrahlenden Bereichs herausgehen, der im Querschnitt ein maximales, lineares Maß aufweist, beispielsweise die Strahlen I oder II, auf die Grenze "Substrat-Luft" unter einem rechten Winkel; diese Strahlen verlassen also den Kristall (die Verluste der Fresnel-Reflexion betragen 16 %). Damit der Strahl III, der aus dem Rand des ausstrahlenden Bereichs herausgeht, die Außengrenze unter dem Winkel p treffen kann, der kleiner als der kritische Winkel ist (für das Material AIN beträgt dieser Winkel 25°), ist die Erfüllung der folgenden Bedingung notwendig: der Durchmesser der halbkugeligen Oberfläche ist D ≥ 1,9d. Bei realen Flächen des Kristalls von1 mm² soll die Stärke des Substrats 1 für die Formierung der notwendigen Halbkugel im Rahmen von 3 mm liegen, um keine Probleme bei der Verwendung der Substrate aus Metallnitriden, die aus einem räumlichen Barren ausgeschnitten werden, zu erhalten.

Die vorliegende Erfindung kann eine breite Anwendung in verschiedenen Zweigen der Wirtschaft finden. Die vorgeschlagenen Halbleiterquellen des Weißlichts können als Elemente von Beleuchtungseinrichtungen, insbesondere in Systemen der LED- und lichtoptischen Mastlichtsignale, als Signalvorrichtungen bei individuellen Rettungsmitteln oder für die Beleuchtung von konstruktiven Möbelelementen und Werbeschildern eingesetzt werden. Besonders aussichtsreich ist die Verwendung der vorliegenden Erfindung in Beleuchtungsvorrichtungen, die für die Straßenbeleuchtung und die Beleuchtung von Räumen vorgesehen sind.

Die Lichtemissionsdiode gemäß der Erfindung ist im Forschungslaboratorium für die optische Messungen ZAO "Swetlana-Optoelektronik" getestet worden und hat eine hohe, optische Wirksamkeit gezeigt.

## Patentansprüche

1. Lichtemissionsdiode aus einem Substrat (1), einer epitaxialen Heterostruktur auf der Basis von festen Lösungen von Metallnitriden der dritten Gruppe Alₓln_{y}GA_{1-(x+y)}N (O ≤ x ≤ 1, 0 ≤ y ≤ 1) mit einem p-n-Übergang, der durch die Reihenfolge von epitaxialen Schichten (2 und 4) des n- und p-Leitfähigkeitstyps gebildet ist, ferner aus Metallkontakten, die auf der Seite der epitaxialen Schichten liegen, wobei mindestens ein Metallkontakt auf der Außenoberfläche der
epitaxialen Schichten befestigt ist,
**dadurch gekennzeichnet,**
**dass** das Substrat (1) aus einem Monokristall aus einem Metallnitrid der dritten Gruppe A^{III}N gebildet ist, dass in den epitaxialen Schichten auf der Seite der Außenoberfläche eine Mezzastruktur gebildet ist, in der eine Nut (7) in einer solchen Tiefe ausgeätzt ist, die größer als die Übergangstiefe des p-n-Übergangs ist, dass die Nut (7) die Mezzastruktur in zwei Bereiche teilt und dass ein Metallkontakt (5) auf der Außenoberfläche eines Bereichs (A) der Mezzastruktur und ein weiterer Metallkontakt (6) auf der Außenoberfläche eines anderen Bereichs (B) der Mezzastruktur angebracht ist und dabei an der Seitenwand der Nut (7) auf deren Boden liegt.

2. Lichtemissionsdiode nach Anspruch 1,
**dadurch gekennzeichnet,**
**dass**, falls die Fläche jenes Bereichs (A) der Mezzastruktur, die einen Metallkontakt (5) nur auf seiner Außenoberfläche aufweist, 0,1 mm² überschreitet, in dieser Fläche innere Nuten (9) gebildet sind, die sie in der Gesamtheit der Mezzastrukturen (8) teilen.

3. Lichtemissionsdiode nach Anspruch 1 oder 2,
**dadurch gekennzeichnet,**
**dass** die Höhe (H) der Mezzastruktur die Stärke der epitaxialen Schichten überschreitet.

4. Lichtemissionsdiode nach einem der Ansprüche 1 bis 3,
**dadurch gekennzeichnet,**
**dass** im Falle der Ausführung des Substrats (1) aus leitendem Material die Tiefe der Nut (7) und/oder die Tiefe der inneren Rinnen (9), die die Mezzastruktur in der Gesamtheit der Mezzastrukturen (8) teilt, die Stärke der epitaxialen Schichten überschreiten bzw. überschreitet.

5. Lichtemissionsdiode nach einem der Ansprüche 1 bis 4,
**dadurch gekennzeichnet,**
**dass** die Seitenwände der Mezzastruktur und/oder Seitenwände der Nut (7) und/oder Seitenwände der inneren Nuten (9), die die Mezzastruktur in der Gesamtheit der Mezzastrukturen (8) teilen, einen Winkel (α) von 25-60° der Vertikalen zur Substratfläche (1) aufweisen.

6. auf der Oberfläche des Substrats (1) mit dem Ätzverfahren ein Mikrorelief (10) mit einem charakteristischen Maß von 0,1-0,3 µm gebildet ist.

7. Lichtemissionsdiode nach einem der Ansprüche 1 bis 6,
**dadurch gekennzeichnet,**
**dass** die Stärke des Substrats (1) als ausreichend für die Formgebung einer Halbkugel mit demjenigen Zentrum gewählt wird, das mit dem geometrischen Zentrum desjenigen Bereichs (3) der Mezzastruktur, der einen Metallkontakt (5) nur auf seiner Außenoberfläche aufweist, oder mit dem geometrischen Zentrum der Gesamtheit der Mezzastruktur (8) übereinstimmt.
